# EUROPEAN PATENT APPLICATION

(11) **EP 4 787 429 A1**
(43) Date of publication of application: **05.08.2026**
(21) Application number: 24871704.3
(22) Date of filing: 29.08.2024
(51) Int. Cl.: H01L 21/312, C01B 33/18, C08K 3/36, C08L 83/16

(54) **SUBSTRATE CHARACTERIZED BY INCLUDING METHYLHYDROSILOXANE COMPOSITION FILM OR METHYLHYDROSILOXAZANE COMPOSITION FILM, IN WHICH SILICA FINE PARTICLES ARE DISPERSED, AND METHOD FOR PRODUCING SAME**

(30) Priority: 29.09.2023 JP 2023169901
(71) Applicant: Traditional Intelligence Corporation, Musashino-shi, Tokyo 180-0003 (JP)
(72) Inventor: SHIMIZU Yasuo, Musashino-shi, Tokyo 180-0003 (JP)
(74) Representative: Balder IP Law, S.L.
(86) International application number: PCT/JP2024/030936
(87) International publication number: WO 2025/069903

(57) **Abstract**

Provided is a substrate (10) that comprises a methylhydrosiloxane composition or a film (12) composed of a methylhydrosiloxazane composition, in which silica fine particles are dispersed as a matrix material.

## Description

### TECHNICAL FIELD

The present invention relates to a substrate containing a methylhydrosiloxane composition film or methylhydrosiloxazane composition film in which silica fine particles are dispersed.

### BACKGROUND

There has been a demand for a technique capable of embedding and planarizing grooves (steps) in a substrate with a silica-based film while providing superior stability and productivity, and without causing cracks or delamination. Commonly in semiconductors, liquid-crystal panels, and the like, elements and wiring are formed on a single semiconductor wafer or glass substrate by lamination from lower layers toward upper layers. Therefore, in order to facilitate the formation of upper layers and to reduce misalignment in the planar direction during lithography, it is necessary to planarize protrusions and steps formed by the elements and wiring. In particular, with recent demand for higher integration and higher resolution in semiconductor chips and liquid-crystal panels, the heights (depths) of such protrusions and steps tend to increase and may reach 1 µm or more, therefore increasing the importance of embedding and planarization.

In addition, when producing semiconductor elements formed by laminating different types of chips such as CPUs and memories, or multiple chips of the same type, so-called chip-on-wafer, which have attracted attention as next-generation semiconductors, it is necessary, after placing diced chips on a base wafer and fixing the chips, to embed grooves between adjacent chips. With this process, the depth of the grooves is typically 10 µm or more, and a film capable of embedding and planarizing the grooves is required.

It should be noted that silica-based coating composition used for purposes such as stress relaxation, improvement of hardness, improvement of heat resistance, and imparting thixotropy have been disclosed (Patent Document 1). The silica-based coating composition contains a matrix components which holds silica fine particles in a dispersed state. The carbon content ratio in the silica fine particles and in the silica-based coating composition is set to 5 wt% or less.

In addition, a technique has been disclosed (Patent Document 2) that provides a trench-filling composition suitable for embedding silicon oxide into trenches formed in a substrate, the composition providing silicon oxide coating films which have high trench embeddability, a reduced curing shrinkage rate, and excellent crack resistance. In this technique, a trench-filling composition containing a hydrogenated polysilazane compound and a reaction product having a structure derived from silica particles is described.

### CITATION LIST

### PATENT LITERATURE

Patent Document 1: JP2019-182893A
Patent Document 2: JP2010-177647A

### SUMMARY

### TECHNICAL PROBLEM

Meanwhile, a chemical vapor deposition method (CVD method) is also known as a technique for forming such films. In a chemical vapor deposition method, the film is formed along the shape of the substrate, making it unsuitable for embedding and planarizing groove portions. In addition, the film formation rate is low, and productivity is poor.

Furthermore, when a sol-gel solution or a siloxane compound containing bulky organic groups such as ethyl groups is used as a matrix material, volume shrinkage is large because curing proceeds with dehydration during conversion to silica, and cracks or delamination are likely to occur when a thick film of 0.5 µm or more is formed, making it difficult to ensure stability and productivity.

Still further, when polyimide or the like is used as a heat-resistant organic resin, controlling the shape is problematic as thermal changes such as expansion and contraction are larger compared with those of silica-based materials. In addition, there are manufacturing difficulties, such as decomposition or elution of organic components during etching process or cleaning process.

Yet further, in the techniques described in the above citation list, a polymer containing no organic groups, such as hydrogenated polysilazane, is used as a matrix material. Therefore, after heating or curing, an inorganic silica material that substantially contains no carbon components or only a small amount thereof is formed. Therefore, although it has the advantage of being able to form a film with high hardness and high strength, it has the disadvantage that large stresses are generated during heating or curing, and that cracks or delamination are likely to occur during manufacturing or due to bending or thermal changes after manufacturing. It should be noted that this disadvantage becomes more significant in a substrate having a step than on a flat substrate, and becomes still more significant when a substrate having a taller step is used. In addition, since its solubility in solvents is low and its reactivity with moisture is high, uniform mixing with silica fine particles is difficult, and there is a problem in the stability of storing the mixed solution.

### SOLUTION TO PROBLEM

One aspect of the present invention is a substrate containing a film in which silica fine particles are dispersed in a methylhydrosiloxane composition or a methylhydrosiloxazane composition as a matrix material.

Here, it is preferable that the substrate has a step of 1 µm or more, and the film is embedded at a depth of 1 µm or more from the bottom part of the step.

In addition, it is preferable that the film has an average carbon content of 8 wt % or more and 18 wt % or less.

Furthermore, it is preferable that the silica fine particles have an average primary particle size of 5 nm or more and 150 nm or less.

Another aspect of the present invention is a method for producing a substrate, containing applying to the substrate a material in which silica fine particles are dispersed in polymethylhydrosilazane or polymethylhydrosiloxazane with a weight-average molecular weight of 400 or more and 20,000 or less as a matrix material, and heating the applied material.

In addition, it is preferable that the silica fine particles have an average primary particle size of 5 nm or more and 150 nm or less.

Furthermore, it is preferable that a mixing ratio (weight ratio) of the silica fine particles relative to the matrix material is 3 wt% or more and 200 wt% or less.

In addition, it is preferable that a ratio of Si-H bonds to Si-Me bonds in a structure of the matrix material is 0.3 or more and 0.9 or less, and a ratio of N-H bonds to Si-Me bonds is 0.4 or more and 1.1 or less.

### ADVANTAGEOUS EFFECTS OF INVENTION

According to the present invention, it becomes possible to provide a film-attached substrate in which a film is formed without causing cracks or delamination. In particular, it becomes possible to provide a film-attached substrate in which a film is formed without causing cracks or delamination even at a film thickness of 1 µm or more.

### BRIEF DESCRIPTION OF DRAWINGS

[FIG. 1] FIG. 1 is a schematic cross-sectional view illustrating a configuration of a film-attached substrate in an embodiment of the present invention.
[FIG. 2] FIG. 2 is a schematic cross-sectional view illustrating a configuration of a film-attached substrate in an embodiment of the present invention.
[FIG. 3] FIG. 3 is a schematic cross-sectional view illustrating a configuration of a film-attached substrate in an embodiment of the present invention.
[FIG. 4] FIG. 4 is a schematic cross-sectional view illustrating a configuration of a film-attached substrate in an embodiment of the present invention.
[FIG. 5] FIG. 5 is a diagram illustrating a compositional change of a matrix material in an embodiment of the present invention.

### DESCRIPTION OF EMBODIMENTS

### Configuration of Substrate

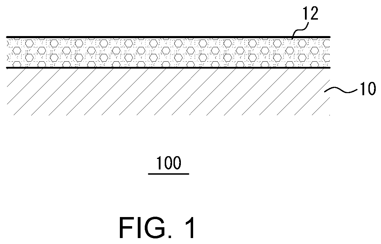

As shown in FIG. 1, a film-attached substrate 100 in an embodiment of the present invention is configurated by laminating a substrate 10 and a film 12.

The film 12 is formed on the surface of the substrate 10. The substrate 10 is not particularly limited, and may be, for example, a semiconductor substrate. The substrate 10 may be, for example, a semiconductor substrate on which elements constituting an electric circuit such as transistors or capacitors are formed, or a substrate on which are formed color filters and the like of a liquid crystal panel.

The film 12 formed on a surface of the substrate 10 is used as an insulating film, an embedding layer, a planarization film, a passivation film, and the like, in the substrate 10 of a semiconductor, a liquid crystal panel, or the like. Specifically, the film 12 is used as an insulating film, a planarization film, or an embedding film for elements or wiring constituting an electric circuit such as transistors or capacitors, or a structure in which a circuit is constituted. The film 12 is also used as an embedding layer or a planarization film for grooves between chips that are formed when upper and lower layers are fixed or upper-layer chips are placed at a lamination of semiconductor chips themselves. The film 12 is also used, for example, as an embedding layer or a planarization film for uneven portions such as color filters of liquid crystal panels. The film 12 is also used, for example, as a passivation film (barrier film) for blocking moisture or oxygen that oxidize and deteriorate electric circuits or electric elements.

The film 12 is constituted of a material in which silica fine particles are dispersed in a methylhydrosiloxane composition or a methylhydrosiloxazane composition as a matrix material. The methylhydrosiloxane composition is a compound having Si-O bonds as a backbone, and the methylhydrosiloxazane composition is a compound having Si-O bonds and partially Si-N bonds as a backbone, and these compositions are a compound containing H-Si-Me bonds (where Me is a methyl group CH₃).

Factors for selecting the methylhydrosiloxane composition or the methylhydrosiloxazane composition as a matrix material include (1) they have a backbone of Si-O bonds similar to silica fine particles and the substrate 10 of silicon or glass; (2) Si-Me bonds make it possible to provide the film 12 with a function of achieving both strength and flexibility; and (3) Si-H bonds increase reactivity with Si-OH bonds and the like on surfaces of the silica fine particles and the substrate 10, thereby enabling enhancement of adhesion to the silica fine particles and the substrate 10.

As a material for forming the methylhydrosiloxane composition or the methylhydrosiloxazane composition serving as a matrix material, polymethylhydrosilazane or polymethylhydrosiloxazane having a weight-average molecular weight of 400 or more and 20,000 or less is preferable. When the weight-average molecular weight is less than 400, the organic solvent, in which silica fine particles are mixed and dispersed, may flow when applied to the base material and cannot be fixed on the surface of the substrate 10, or it may vaporize during heating, making it difficult to form a uniform film 12. Alternatively, when the weight-average molecular weight exceeds 20,000, there is a problem that it becomes difficult to dissolve the material in an organic solvent when silica fine particles are mixed and dispersed.

It is further preferable that the ratio of Si-H bonds to Si-Me bonds in polymethylhydrosilazane or polymethylhydrosiloxazane, which is a material for forming the methylhydrosiloxane composition or the methylhydrosiloxazane composition as a matrix material, is within a range of 0.3 or more and 0.9 or less. It is also preferable that the ratio of N-H bonds to Si-Me bonds in the polymethylhydrosilazane or polymethylhydrosiloxazane is within a range of 0.4 or more and 1.1 or less. When the ratio of Si-H bonds to Si-Me bonds is less than 0.3 or the ratio of N-H bonds to Si-Me bonds is less than 0.4, adhesion to the substrate 10 or the silica fine particles decreases when the organic solvent in which the silica fine particles are mixed and dispersed is applied to the substrate 10, and cracks or delamination may occur in the film 12 after heating. Alternatively, when the ratio of Si-H bonds to Si-Me bonds exceeds 0.9 or the ratio of N-H bonds to Si-Me bonds exceeds 1.1, there is a problem that viscosity increases when the silica fine particles are mixed and dispersed in the organic solvent, or stability in storage of the solution after mixing and dispersing decreases.

It is preferable that the silica fine particles be present dispersed in the film 12. The silica fine particles may be colloidal silica, fused silica, fumed silica, or silica produced by a sintering pulverization method or a vapor combustion method. In order to enhance dispersibility in an organic solvent, silica fine particles whose surfaces are treated with a silane coupling agent or the like may also be used. It is preferable that the primary particle size (average diameter) of the silica fine particles is 5 nm or more and 150 nm or less. When the primary particle size (average diameter) of the silica fine particles is less than 5 nm, there arises a problem that the particles cannot be dispersed in an organic solvent due to aggregation or cannot be uniformly mixed with polymethylhydrosilazane or polymethylhydrosiloxazane. On the other hand, when the primary particle size (average diameter) of the silica fine particles exceeds 150 nm, there arises a problem that the particles cannot be stably dispersed and retained in the organic solvent due to sedimentation. Further, when applied to devices such as liquid crystal panels, by setting the primary particle size (average diameter) of the silica fine particles to 5 nm or more and 150 nm or less, transparency of the film 12 in a visible light region can be enhanced.

It is preferable that a mixing ratio (weight ratio) of the silica fine particles to the polymethylhydrosilazane or polymethylhydrosiloxazane, which is a material for forming the methylhydrosiloxane composition or the methylhydrosiloxazane composition serving as a matrix material, is within a range of between 3 wt% and 200 wt%. When the mixing ratio (weight ratio) is less than 3 wt%, problems may arise such as the mixture flowing when applied to the substrate 10 such that it cannot be fixed on the substrate 10, or the generation of cracks in the film 12 after heating. When the mixing ratio (weight ratio) exceeds 200 wt%, forming the uniform film 12 becomes difficult, such that spaces between the fine particles cannot be completely filled when applied to the substrate 10 and only the fine particles are exposed from the film 12, or that roughness occurs in the film 12.

It is preferable that an average carbon content indicating a mixing ratio of the silica fine particles to the methylhydrosiloxane composition or the methylhydrosiloxazane composition serving as a matrix material is 8 wt% or more and 18 wt% or less. When the average carbon content is less than 8 wt%, there is a high possibility that cracks or delamination occur in the formed film 12. Alternatively, when the average carbon content exceeds 18 wt%, there may arise a possibility that strength of the formed film 12 decreases or that shrinkage in a process of forming the film 12 increases, making control of a shape of the film 12 difficult.

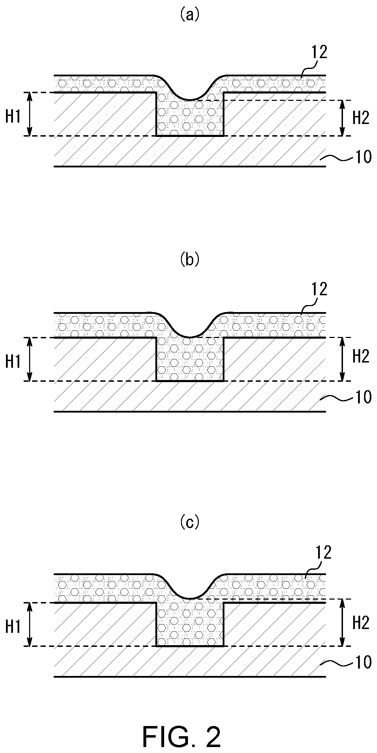

FIG. 2 is a schematic cross-sectional view showing the substrate 10 in which the film 12, in which silica fine particles are dispersed in a methylhydrosiloxane composition or a methylhydrosiloxazane composition as a matrix material, is embedded in a surface having a step.

FIGS. 2(a) to 2(c) show three experimental example relationships between a height (depth) H1 of a step of the substrate 10 and a film thickness H2 of the film 12 embedded in the step. FIG. 2(a) shows a case in which the film thickness H2 of the film 12 embedded in the step is smaller than the height (depth) H1 of the step of the substrate 10. FIG. 2(b) shows a case in which the height (depth) H1 of the step of the substrate 10 and the film thickness H2 of the film 12 embedded in the step are equal. FIG. 2(c) shows a case in which the film thickness H2 of the film 12 embedded in the step is larger than the height (depth) H1 of the step of the substrate 10.

In this embodiment, cracks or delamination did not occur in the film 12 after formation in any of the cases shown in FIGs. 2(a) to 2(c), and a stable film 12 could be formed. In particular, even when the height (depth) H1 of a step provided on the substrate 10 is 1 µm or more and the film thickness H2 of the film 12 embedded in the step is 1 µm or more, cracks or delamination did not occur. That is, according to this embodiment, even when a film thickness of the film 12 is 1 µm or more, cracks or delamination did not occur, and the stable film 12 could be formed.

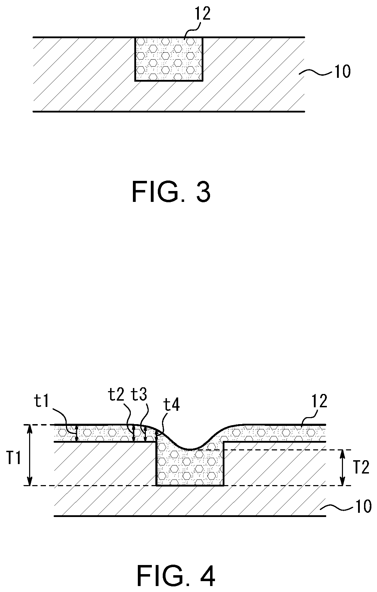

In addition, as shown in FIG. 3, by polishing and removing the film outside the step using a method such as CMP after embedding, it becomes possible to planarize an entire substrate. In such a case, it is preferable that the film 12 be formed such that the film thickness H2 of the film 12 embedded in the step becomes equal to a height of the step (FIG. 2(b)), or that the film 12 be formed such that the film thickness H2 of the film 12 embedded in the step becomes larger than a height of the step (FIG. 2(c)).

In addition, when a method for applying an organic solvent containing polymethylhydrosilazane or polymethylhydrosiloxazane in which the silica fine particles are dispersed to the substrate 10 is a method in which the solvent is fixed while being vaporized, such as spin coating, spray coating, slit coating, gravure coating, or roll coating, is used, there is inherently a phenomenon in which the coating liquid flows down from an upper portion of the step into an inside of the step. As a result, as shown in FIG. 4, there is a tendency that a film thickness T2 inside the step becomes larger than a maximum film thickness t1 at an outer portion sufficiently distant from the step outside the step of the substrate 10. In addition, film thicknesses t1 to t4 of the film 12 at peripheral portions outside the step of the substrate 10 tend to become smaller as they approach the step.

Here, a pattern provided on a surface of the substrate 10 is not particularly limited in shape, arrangement, or position. For example, the pattern may be holes in a linear shape, a circular shape, a rectangular shape, or the like. In particular, when a height (depth) H1 of a step of the pattern is 1 µm or more, an effect by the film 12 becomes remarkable. In addition, although a width of the pattern is not particularly limited, a minimum width is preferably 30 nm or more in consideration of a size of the silica fine particles to be dispersed in the film 12. On the other hand, depending on the application, it is also applicable when a width of the pattern is 1 µm or more, or 1 mm or more. Further, a sidewall of the step need not be vertical, and may be in a tapered shape or an inverted tapered shape.

### Production Method

The film 12 in this embodiment is formed by first applying an organic solvent in which silica fine particles are mixed and dispersed in polymethylhydrosilazane or polymethylhydrosiloxazane to a surface of the substrate 10, then fixing it by volatilizing the organic solvent, and heating it, by which the polymethylhydrosilazane or polymethylhydrosiloxazane is oxidized and is converted into a methylhydrosiloxane composition or a methylhydrosiloxazane composition.

Here, a weight-average molecular weight of the polymethylhydrosilazane or the polymethylhydrosiloxazane is preferably 400 or more and 20,000 or less. In addition, it is preferable that an average primary particle size of the silica fine particles to be dispersed is 5 nm or more and 150 nm or less. In addition, it is preferable that a mixing ratio (weight ratio) of the silica fine particles to the polymethylhydrosilazane or the polymethylhydrosiloxazane is within a range of 3 to 200 wt%

In addition, it is preferable that a ratio of Si-H bonds to Si-Me bonds in the polymethylhydrosilazane or the polymethylhydrosiloxazane is within a range of 0.3 to 0.9. In addition, it is preferable that a ratio of N-H bonds to Si-Me bonds in the polymethylhydrosilazane or the polymethylhydrosiloxazane is within a range of 0.4 to 1.1.

Because the polymethylhydrosilazane or the polymethylhydrosiloxazane has a property of reacting with moisture to polymerize, when moisture is contained in these organic solvents, there may arise problems such that a film thickness of the film 12 changes or coating becomes difficult due to an increase in molecular weight or gelation. Therefore, it is preferable that moisture in the organic solvent is 1 wt% or less.

The organic solvent is preferably a single solvent or a combination of solvents selected from aromatic hydrocarbons such as toluene, xylene, and trimethylbenzene; saturated hydrocarbons such as hexane, hexene, and octane; ethers such as butyl ether, amyl ether, and anisole; esters such as ethyl acetate, propyl acetate, and butyl acetate; and ketones such as diethyl ketone, methyl isobutyl ketone, and cyclohexanone.

A method for applying an organic solvent containing the polymethylhydrosilazane or the polymethylhydrosiloxazane in which the silica fine particles are dispersed to the substrate 10 may employ a method of fixing the solvent while volatilizing it, such as spin coating, spray coating, slit coating, gravure coating, or roll coating, but the coating method is not limited to these.

In addition, when embedding deep grooves or steps of several µm or more, it is possible to form a thick film by repeatedly performing a series of operations of applying a mixed solution of the polymethylhydrosilazane or the polymethylhydrosiloxazane and the silica fine particles to the substrate, fixing it by volatilizing the organic solvent, and heating it. Although it is also possible to form a film of several µm or more at one time, this requires increasing the viscosity of the coating liquid, creating difficulties in handling the coating liquid or the coating apparatus.

After an organic solvent containing polymethylhydrosilazane or polymethylhydrosiloxazane in which silica fine particles are dispersed is applied to the substrate 10 and the organic solvent is volatilized to fix the coating, a heat treatment is performed. The heating method is not particularly limited, and, for example, an oven or a hot plate may be used. The heating temperature is preferably 150 °C or more and 600 °C or less. The atmosphere during heating is preferably an oxidizing gas such as air, oxygen, or steam. Dry nitrogen or argon may also be used as a balance gas.

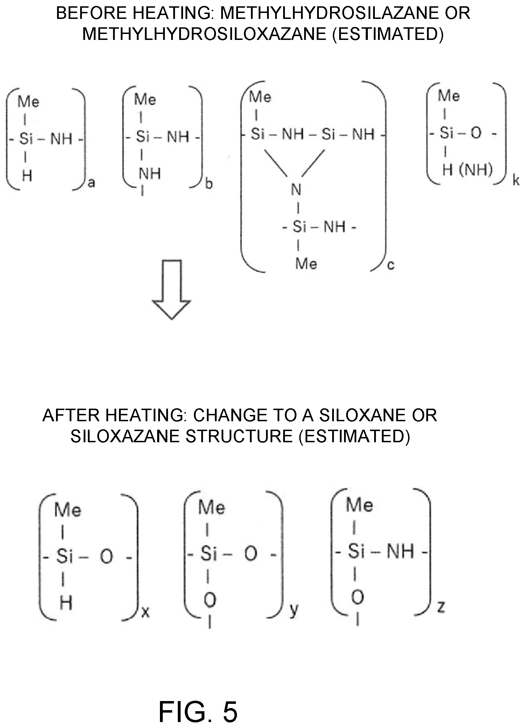

FIG. 5 is a diagram showing an estimated change in the structure of the matrix portion before and after heating. In FIG. 5, a, b, c, k, and x, y, z are each present randomly. Before heating, in the case of polymethylhydrosilazane, the structure is constituted by a, b, and c, and in the case of polymethylhydrosiloxazane, the structure is constituted by a, b, c, and k. Here, the compositional ratios of a, b, c, and k are such that a is 5% to 70%, b is 10% to 60%, c is 3% to 20%, and k is 0% to 15%. After heating, part or all of the Si-N bonds are oxidized, and in the case of the methylhydrosiloxane composition, the structure is constituted by x and y, and in the case of the methylhydrosiloxazane composition, the structure is constituted by x, y, and z. Here, the compositional ratios of x, y, and z are such that x is 1% to 20%, y is 70% to 100%, and z is 0% to 20%. The compositional ratios are combined so as not to contradict each other in each combination. For example, when y is 100%, the others x and z are 0%.

### Examples

### Synthesis of Polymethylhydrosilazane A

A 2-L stainless-steel autoclave was equipped with a stirrer, nozzles capable of injecting and discharging liquids or gases into the liquid phase and the gas phase, and cooling and control devices capable of controlling the temperature of the contents. After sufficiently drying the inside of the autoclave using dry nitrogen, 300 g of toluene dehydrated by treatment with a molecular sieve and 300 g of pyridine were charged, and the mixture was cooled to 0 °C while stirring. Then, 50 g of methylhydrodichlorosilane was gradually added, and, while maintaining the temperature at 0 °C, 50 g of dry ammonia was introduced over 2 hours. After introducing dry nitrogen to remove the excess ammonia, the reaction solution was filtered through an SUS316 filter having a filtration accuracy of 25 µm. To the obtained filtrate, 500 g of toluene dried with a molecular sieve was mixed, and the mixture was distilled using a rotary evaporator at a bath temperature of 50 °C until the contents reached approximately 200 g. Thereafter, 200 g of dried toluene was mixed with the distilled mixture, and the solvent was sufficiently removed using a rotary evaporator at the same bath temperature of 50 °C, to obtain approximately 15 g of a viscous liquid.

Using CDCl3 as a lock solvent, 1H-NMR (400 MHz) measurement was conducted on the obtained viscous liquid. A peak at 0.1-0.2 ppm attributed to Si-Me bonds, peaks at 0.4-1.8 ppm attributed to N-H bonds, and a peak at 4.1-5.1 ppm attributed to Si-H bonds were observed. Based on the integral ratios of the respective peaks (proton-number basis), the ratio of Si-H bonds to Si-Me bonds was 0.82, and the ratio of N-H bonds to Si-Me bonds was 0.75.

Next, the viscous liquid was applied onto a KBr plate, and an FT-IR spectrum was measured using an FT-IR apparatus (Jasco, model FT/IR-4100), and absorptions at 1,180 and 3,370 cm⁻¹ attributed to N-H bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed.

Further, when GPC measurement was conducted on the viscous liquid, the weight-average molecular weight in terms of polystyrene was 850.

Based on the above analytical results, the obtained viscous liquid was identified as polymethylhydrosilazane.

### Synthesis of Polymethylhydrosilazane B

A 2-L stainless-steel autoclave was equipped with a stirrer, nozzles capable of injecting and discharging liquids or gases into the liquid phase and the gas phase, and cooling and control devices capable of controlling the temperature of the contents. After sufficiently drying the interior of the autoclave using dry nitrogen, 300 g of toluene dehydrated by treatment with a molecular sieve and 300 g of pyridine were charged, and the mixture was cooled to 0 °C while stirring. Then, 20 g of methylhydrodichlorosilane and 30 g of methyltrichlorosilane were gradually added, and while maintaining the temperature at 0 °C, 50 g of dry ammonia was introduced over 2 hours. After introducing dry nitrogen to remove the excess ammonia, the reaction solution was filtered through an SUS316 filter having a filtration accuracy of 25 µm. To the obtained filtrate, 500 g of toluene dried with a molecular sieve was mixed, and the mixture was distilled using a rotary evaporator at a bath temperature of 50 °C until the contents reached approximately 200 g. Thereafter, 200 g of dried toluene was mixed with the distilled mixture, and the solvent was sufficiently removed using a rotary evaporator at the same bath temperature of 50 °C, to obtain approximately 18 g of a viscous liquid.

Using CDCl3 as a lock solvent, 1H-NMR (400 MHz) measurement was conducted on the obtained viscous liquid. A peak at 0.1-0.2 ppm attributed to Si-Me bonds, a peak at 0.4-1.8 ppm attributed to N-H bonds, and a peak at 4.1-5.1 ppm attributed to Si-H bonds were observed. Based on the integral ratios of the respective peaks (proton-number basis), the ratio of Si-H bonds to Si-Me bonds was 0.39, and the ratio of N-H bonds to Si-Me bonds was 1.05.

Next, the viscous liquid was applied onto a KBr plate, and an FT-IR spectrum was measured using an FT-IR apparatus (Jasco, model FT/IR-4100), and absorptions at 1,180 and 3,370 cm⁻¹ attributed to N-H bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed.

Further when GPC measurement was conducted on the viscous liquid, the weight-average molecular weight in terms of polystyrene was 1,800.

Based on the above analytical results, the obtained viscous liquid was identified as polymethylhydrosilazane.

### Synthesis of Polymethylhydrosiloxazane C

A 2-L stainless-steel autoclave was equipped with a stirrer, nozzles capable of injecting and discharging liquids or gases into the liquid phase and the gas phase, and cooling and control devices capable of controlling the temperature of the contents. After sufficiently drying the inside of the autoclave with dry nitrogen, 50 g of pyridine dehydrated with a molecular sieve was charged, and the mixture was cooled to 0 °C while stirring. Then, a solution obtained by dissolving 12 g of the above-obtained polymethylhydrosilazane A in 90 g of toluene dehydrated with a molecular sieve was gradually added. Next, 40 g of pyridine dehydrated with a molecular sieve and 0.5 g of pure water were mixed, and the mixture was introduced over 1 hour into the autoclave in which polymethylhydrosilazane A had been dissolved in pyridine and toluene. After introducing dry nitrogen to perform a replacement in the autoclave, the contents were filtered through a 5 µm Teflon (registered trademark) filter. To the obtained filtrate, 100 g of toluene dried with a molecular sieve was added and mixed, and the mixture was distilled using a rotary evaporator at a bath temperature of 50 °C until the contents reached approximately 80 g. Thereafter, 100 g of dried toluene was added and mixed, and the solvent was sufficiently removed using a rotary evaporator at the same bath temperature of 50 °C to obtain approximately 12 g of a viscous liquid.

Using CDCl3 as a lock solvent, 1H-NMR (400 MHz) measurement was conducted on the obtained viscous liquid. A peak at 0.1-0.2 ppm attributed to Si-Me bonds, a peak at 0.4-1.8 ppm attributed to N-H bonds, and a peak at 4.1-5.1 ppm attributed to Si-H bonds were observed. Based on the integral ratios of the respective peaks (proton-number basis), the ratio of Si-H bonds to Si-Me bonds was 0.63, and the ratio of N-H bonds to Si-Me bonds was 0.73.

Next, after the obtained viscous liquid was applied to a KBr plate, an FT-IR spectrum was measured using an FT-IR instrument (manufactured by Jasco; model FT/IR-4100), and an absorption at 1,120 cm⁻¹ attributed to Si-O bonds, absorptions at 1,180 and 3,370 cm⁻¹ attributed to N-H bonds, an absorption at 1,250 cm⁻¹ attributed to Si-Me bonds, an absorption at 2,160 cm⁻¹ attributed to Si-H bonds, and an absorption at 2,970 cm⁻¹ attributed to C-H bonds were observed.

Further, when GPC measurement was conducted on the viscous liquid, the weight-average molecular weight in terms of polystyrene was 11,500.

Based on the above analytical results, the obtained viscous liquid was identified as polymethylhydrosiloxazane.

### Synthesis of Polymethylsilazane

A 2-L stainless-steel autoclave was equipped with a stirrer, nozzles capable of injecting and discharging liquids or gases into the liquid phase and the gas phase, and cooling and control devices capable of controlling the temperature of the contents. After sufficiently drying the inside of the autoclave using dry nitrogen, 300 g of toluene dehydrated by treatment with a molecular sieve and 300 g of pyridine were charged, and the mixture was cooled to 0 °C while stirring. Then, 25 g of methylhydrodichlorosilane and 30 g of methyltrichlorosilane were gradually added, and while maintaining the temperature at 0 °C, 50 g of dry ammonia was introduced over 2 hours. After introducing dry nitrogen to remove the excess ammonia, the reaction solution was filtered through an SUS316 filter having a filtration accuracy of 25 µm. To the obtained filtrate, 500 g of toluene dried with a molecular sieve was mixed, and the mixture was distilled using a rotary evaporator at a bath temperature of 50 °C until the contents reached approximately 200 g. Thereafter, 200 g of dried toluene was mixed with the distilled mixture, and the solvent was sufficiently removed using a rotary evaporator at the same bath temperature of 50 °C, to obtain approximately 20 g of a viscous liquid.

Using CDCl3 as a lock solvent, 1H-NMR (400 MHz) measurement was conducted on the obtained viscous liquid. A peak at 0.1-0.2 ppm attributed to Si-Me bonds and a peak at 0.4-1.8 ppm attributed to N-H bonds were observed. Based on the integral ratios of the respective peaks (proton-number basis), the ratio of N-H bonds to Si-Me bonds was 1.22. It was also noted that a peak at 4.1-5.1 ppm attributed to Si-H bonds was not observed.

Next, after the viscous liquid was applied onto a KBr plate, an FT-IR spectrum was measured using an FT-IR instrument (manufactured by Jasco; model FT/IR-4100) t absorptions at 1,180 cm⁻¹ and 3,370 cm⁻¹ attributed to N-H bonds, an absorption at 1,260 cm⁻¹ attributed to Si-Me bonds, and an absorption at 2,970 cm⁻¹ attributed to C-H bonds were observed. It was further noted that no absorption at 2,160 cm⁻¹ attributed to Si-H bonds was observed.

In addition, when GPC measurement was conducted on the viscous liquid, the weight-average molecular weight in terms of polystyrene was 2,400.

Based on the above analytical results, the obtained viscous liquid was identified as polymethylsilazane.

### Synthesis of Hydrogenated Polysilazane

After A 2-L stainless-steel reactor equipped with a stirrer and a cooling device was dried sufficiently with dry nitrogen, 1,500 g of pyridine dried with molecular sieves was introduced and cooled to 0 °C while stirring. Then, 120 g of dichlorosilane was added over 1 hour to form a complex of pyridine and dichlorosilane. Subsequently, while maintaining the temperature at 0 °C, 120 g of dry ammonia was introduced over 5 hours with stirring. After completion of the reaction, the slurry-like product was filtered through a 25-µm SUS316 filter under a dry-nitrogen atmosphere, to obtain 1,000 g of filtrate. When this filtrate was subjected to reduced-pressure distillation using a rotary evaporator at a bath temperature of 40 °C, 30 g of a viscous liquid was obtained.

Next, after the viscous liquid was applied onto a KBr plate, an FT-IR spectrum was measured using an FT-IR instrument (manufactured by Jasco; model FT/IR-4100), and absorptions at 1,180 cm⁻¹ and 3,370 cm⁻¹ attributed to N-H bonds, an absorption at 2,160 cm⁻¹ attributed to Si-H bonds, and absorptions at 850 to 1,050 cm⁻¹ attributed to Si-H or SiN bonds were observed. It was further noted that no absorption at 1,260 cm⁻¹ attributed to Si-Me bonds and no absorption at 2,970 cm⁻¹ attributed to C-H bonds were observed.

Further, when GPC measurement was conducted on the viscous liquid, the weight-average molecular weight in terms of polystyrene was 1,500.

Based on the above analytical results, the obtained viscous liquid was identified as hydrogenated polysilazane.

### Example 1

In a 300-mL glass container, 20 g of colloidal silica (Organo Silica Sol MEK-ST-L, manufactured by Nissan Chemical Industries, Ltd.; average particle size: 45 nm; solid content concentration: 30%) and 50 g of butyl acetate (Tokyo Chemical Industry; A0024, purity > 99%) were mixed and stirred. Then, 20 g of molecular sieves 4A dried sufficiently was added, and the mixture was left to stand at room temperature for 1 day for dehydration treatment. Thereafter, the mixture was distilled with a rotary evaporator at a bath temperature of 50 °C until the contents reached about 30 g.

Subsequently, 100 g of dried butyl acetate was mixed, and the mixture was distilled with a rotary evaporator at the same bath temperature of 50 °C until the contents reached 25 g. After being cooled at room temperature, 6 g of polymethylhydrosilazane A was mixed and stirred well, and the mixture was filtered through a Teflon (registered trademark) membrane filter with filtration accuracy of 1-µm, to obtain a mixed dispersion of colloidal silica and polymethylhydrosilazane A. The mixing ratio of colloidal silica (solid content) to polymethylhydrosilazane A under these conditions was 100 wt%.

The mixed dispersion was dropped onto a 4-inch silicon wafer and spin-coated at 500 rpm for 30 seconds. Thereafter, the wafer was placed on a hot plate heated to 300 °C in air and held for 10 minutes, and after being left to cool, a uniform thin film free from cracks or delamination was formed.

The silicon wafer with the film was cut, and the cross section was observed by SEM (magnification: 10,000 to 80,000 times) using a JSM-IT800 (manufactured by JEOL), upon which it was observed that a film having a thickness of 2.1 µm in which silica fine particles having diameters of 50 to 110 nm were uniformly distributed, was formed. Using a photoelectron spectrometer (ESCA) manufactured by JEOL Ltd., the elemental composition in the film was measured by X-ray photoelectron spectroscopy (after sputtering the resurface), and the carbon content (converted as the atomic amount of carbon relative to the silica-based phase) was 13.1 wt%. Using an FT-IR instrument (manufactured by Jasco; model FT/IR-4100), the FT-IR spectrum of the film was measured by a method in which absorption of a silicon wafer was subtracted as a background, and absorptions at 470 cm⁻¹ and 980 to 1,270 cm⁻¹ attributed to Si-O bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed. Based on these results, the composition of the film was identified as methylhydrosiloxane.

### Example 2

A mixed dispersion of colloidal silica and polymethylhydrosilazane B was obtained in the same manner as in Example 1, with the exception that polymethylhydrosilazane B was used in place of polymethylhydrosilazane A. The mixing ratio of colloidal silica (solid content) to polymethylhydrosilazane B under these conditions was 100 wt%.

The mixed dispersion was dropped onto a 4-inch silicon wafer and spin-coated at 500 rpm for 30 seconds. Thereafter, the wafer was placed on a hot plate heated to 300 °C in air and held for 10 minutes, and after being left to cool, a uniform thin film free from cracks or delamination was formed.

The film-attached silicon wafer was cut, and the cross section was observed by SEM (magnification: 10,000 to 80,000 times) using a model JSM-IT800 manufactured by JEOL, upon which it was observed that a film having a thickness of 2.3 µm in which silica fine particles having diameters of 40 to 100 nm were uniformly distributed was formed. Using a photoelectron spectrometer (ESCA) manufactured by JEOL Ltd., the elemental composition in the film was measured by X-ray photoelectron spectroscopy (after sputtering the resurface), and the carbon content (converted as the atomic amount of carbon relative to the silica-based phase) was 16.8 wt%. Using an FT-IR instrument (model FT/IR-4100, manufactured by Jasco), the FT-IR spectrum of the film was measured by a method of subtracting silicon wafer absorption as a background, and absorptions at 470 and 980-1,270 cm⁻¹ attributed to Si-O bonds, an absorption at 3,370 cm⁻¹ attributed to N-H bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed. Based on these results, the composition of the film was identified as methylhydrosiloxazane.

### Example 3

A mixed dispersion of colloidal silica and polymethylhydrosiloxazane C was obtained in the same manner as in Example 1, with the exception that polymethylhydrosiloxazane C was used in place of polymethylhydrosilazane A. The mixing ratio of colloidal silica (solid content) to polymethylhydrosiloxazane C under these conditions was 100 wt%

The mixed dispersion was dropped onto a 4-inch silicon wafer and spin-coated at 500 rpm for 30 seconds. Thereafter, the wafer was placed on a hot plate heated to 300 °C in air and held for 10 minutes, and after being left to cool, a uniform thin film free from cracks or delamination was formed.

The film-attached silicon wafer was cut, and the cross section was observed by SEM (magnification: 10,000 to 80,000 times) using a model JSM-IT800 manufactured by JEOL, upon which it was observed that a film having a thickness of 2.1 µm in which silica fine particles having diameters of 40 to 110 nm were uniformly distributed was formed. Using a photoelectron spectrometer (ESCA) manufactured by JEOL Ltd., the elemental composition in the film was measured by X-ray photoelectron spectroscopy (after sputtering the resurface), and the carbon content (converted as the atomic amount of carbon relative to the silica-based phase) was 10.8 wt%. Using an FT-IR instrument (model FT/IR-4100, manufactured by Jasco), the FT-IR spectrum of the film was measured by subtracting silicon wafer absorption as a background, and absorptions at 470 and 980-1,270 cm⁻¹ attributed to Si-O bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed. Based on these results, the composition of the film was identified as methylhydrosiloxane.

### Example 4

A mixed dispersion of colloidal silica and polymethylhydrosilazane A was obtained in the same manner as in Example 1, with the exception that 20 g of colloidal silica (manufactured by Nissan Chemical Industries, Ltd., Organo Silica Sol MEK-ST; average particle diameter: 12 nm, solid content concentration: 30%) was used in place of 20 g of colloidal silica (manufactured by Nissan Chemical Industries, Ltd., Organo Silica Sol MEK-ST-L; average particle diameter: 45 nm, solid content concentration: 30%). The mixing ratio of colloidal silica (solid content) to polymethylhydrosilazane A under these conditions was 100 wt%.

The mixed dispersion was dropped onto a 4-inch silicon wafer and spin-coated at 500 rpm for 30 seconds. Thereafter, the wafer was placed on a hot plate heated to 300 °C in air and held for 10 minutes, and after being left to cool, a uniform thin film free from cracks or delamination was formed.

The film-attached silicon wafer was cut, and the cross section was observed by SEM (magnification: 10,000 to 80,000 times) using a model JSM-IT800 manufactured by JEOL, upon which it was observed that a film having a thickness of 1.8 µm in which silica fine particles having diameters of 7 to 20 nm were uniformly distributed was formed. Using a photoelectron spectrometer (ESCA) manufactured by JEOL Ltd., the elemental composition in the film was measured by X-ray photoelectron spectroscopy (after sputtering the resurface), and as a result, the carbon content (converted as the atomic amount of carbon relative to the silica-based phase) was 12.2 wt%. Using an FT-IR instrument (model FT/IR-4100, manufactured by Jasco), the FT-IR spectrum of the film was measured by a method subtracting silicon wafer absorption as a background, and absorptions at 470 and 980-1,270 cm⁻¹ attributed to Si-O bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed. Based on these results, the composition of the film was identified as methylhydrosiloxane.

### Example 5

A mixed dispersion of colloidal silica and polymethylhydrosilazane A was obtained in the same manner as in Example 1, with the exception that the amount of colloidal silica (Organosilica Sol MEK-ST-L manufactured by Nissan Chemical Industries, Ltd.; average particle diameter: 45 nm; solid content concentration: 30%) was changed to 2 g and the mixed amount of polymethylhydrosilazane A was changed to 12 g. The mixing ratio of colloidal silica (solid content) to polymethylhydrosilazane A under these conditions was 5.0 wt%.

The mixed dispersion was dropped onto a 4-inch silicon wafer and spin-coated at 500 rpm for 30 seconds. Thereafter, the wafer was placed on a hot plate heated to 300 °C in air and held for 10 minutes, and after being left to cool, a uniform thin film free from cracks or delamination was formed.

The film-attached silicon wafer was cut, and the cross section was observed by SEM (magnification: 10,000 to 80,000 times) using a model JSM-IT800 manufactured by JEOL. upon which it was observed that a film having a thickness of 1.5 µm in which silica fine particles having diameters of 40 to 110 nm were sparsely but uniformly distributed was formed. Using a photoelectron spectrometer (ESCA) manufactured by JEOL Ltd., the elemental composition in the film was measured by X-ray photoelectron spectroscopy (after sputtering the resurface), and the carbon content (converted as the atomic amount of carbon relative to the silica-based phase) was 17.8 wt%. Using an FT-IR instrument (model FT/IR-4100, manufactured by Jasco), the FT-IR spectrum of the film was measured by subtracting silicon wafer absorption as a background, and absorptions at 470 and 980-1,270 cm⁻¹ attributed to Si-O bonds, absorptions at 3,370 cm⁻¹ attributed to N-H bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed. Based on these results, the composition of the film was identified as methylhydrosiloxazane.

### Example 6

A mixed dispersion of colloidal silica and polymethylhydrosilazane A was obtained in the same manner as in Example 1, with the exception that the amount of colloidal silica (Organosilica Sol MEK-ST-L manufactured by Nissan Chemical Industries, Ltd.; average particle diameter: 45 nm; solid content concentration: 30%) was changed to 25 g and the mixed amount of polymethylhydrosilazane A was changed to 4 g. The mixing ratio of colloidal silica (solid content) to polymethylhydrosilazane A under these conditions was 187.5 wt%.

The mixed dispersion was dropped onto a 4-inch silicon wafer and spin-coated at 500 rpm for 30 seconds. Thereafter, the wafer was placed on a hot plate heated to 300 °C in air and held for 10 minutes, and after being left to cool, a uniform thin film free from cracks or delamination was formed.

The film-attached silicon wafer was cut, and the cross section was observed by SEM (magnification: 10,000 to 80,000 times) using a model JSM-IT800 manufactured by JEOL, upon which it was observed that a film having a thickness of 1.9 µm in which silica fine particles having diameters of 50 to 110 nm were uniformly distributed was formed. Using a photoelectron spectrometer (ESCA) manufactured by JEOL Ltd., the elemental composition in the film was measured by X-ray photoelectron spectroscopy (after sputtering the resurface), and the carbon content (converted as the atomic amount of carbon relative to the silica-based phase) was 8.1 wt%. Using an FT-IR instrument (model FT/IR-4100, manufactured by Jasco), the FT-IR spectrum of the film was measured by a method subtracting silicon wafer absorption as a background, and absorptions at 470 and 980-1,270 cm⁻¹ attributed to Si-O bonds, an absorption at 1,260 cm⁻¹ attributed to Si-Me bonds, an absorption at 2,160 cm⁻¹ attributed to Si-H bonds, and an absorption at 2,970 cm⁻¹ attributed to C-H bonds were observed. Based on these results, the composition of the film was identified as methylhydrosiloxane.

### Example 7

The mixed dispersion of colloidal silica and polymethylhydrosilazane B described in Example 2 was dropped onto a silicon wafer having a linear groove with a width of 40 µm and a maximum depth of 30 µm, and spin-coated at 500 rpm for 30 seconds. Thereafter, the wafer was placed on a hot plate heated to 300 °C in air and held for 10 minutes, and after being left to cool, a thin film free from cracks or delamination was formed.

The film-attached silicon wafer was cut, and the cross section of the linear groove portion was observed by SEM (magnification: 10,000 to 80,000 times) using a model JSM-IT800 manufactured by JEOL, upon which it was observed that a thin film having the film thickness (H2) of 12.5 µm at the center of the groove width and the film thickness of 2.2 µm outside the groove (at a position 2 mm away from the groove edge), and in which silica fine particles having diameters of 50 to 110 nm were uniformly distributed both inside and outside the groove, was formed. Again, no cracks or delamination were observed.

### Comparative Example 1

A mixed dispersion of colloidal silica and polymethylsilazane was obtained in the same manner as in Example 2, with the exception that polymethylsilazane was used in place of polymethylhydrosilazane B. The obtained mixed dispersion was dropped onto a silicon wafer having a linear groove with a width of 40 µm and a maximum depth of 30 µm, and spin-coated at 500 rpm for 30 seconds. Thereafter, the wafer was placed on a hot plate heated to 300 °C in air and held for 10 minutes, and after being left to cool, a thin film was formed.

Visual observation of the formed thin film revealed delamination and cracks at the portion starting from the groove. The film-attached silicon wafer was cut, and the cross section of the linear groove portion was observed by SEM (magnification: 10,000 to 80,000 times) using a model JSM-IT800 manufactured by JEOL. Delamination of the film from the substrate was observed inside the groove, and measurement of the film thickness was not possible. The film thickness at a portion outside the groove where no delamination occurred (at a portion 2 mm away from the groove edge) was 1.9 µm. It was further observed that a thin film in which particles having diameters of 50 to 110 nm were uniformly distributed was formed outside the groove.

### Comparative Example 2

A mixed dispersion of colloidal silica and hydrogenated polysilazane was obtained in the same manner as in Example 2, with the exception that hydrogenated polysilazane was used in place of polymethylhydrosilazane B. The obtained mixed dispersion was dropped onto a silicon wafer having a linear groove with a width of 40 µm and a maximum depth of 30 µm, and spin-coated at 500 rpm for 30 seconds. Thereafter, the wafer was placed on a hot plate heated to 300 °C in air and held for 10 minutes, and after being left to cool, a thin film was formed.

Visual observation of the formed thin film revealed numerous delamination and cracks were observed over the entire surface of the substrate. The thin film-attached silicon wafer was cut, and the cross section of the linear groove portion was observed by SEM (magnification: 10,000 to 80,000 times) using a model JSM-IT800 manufactured by JEOL. Delamination of the film from the substrate was observed both inside and outside the groove, and measurement of the film thickness was not possible.

### Configuration of the Invention

### Configuration 1

A substrate containing a film in which silica fine particles are dispersed in a methylhydrosiloxane composition or a methylhydrosiloxazane composition as a matrix material.

### Configuration 2

The substrate according to Configuration 1, in which the substrate has a step of 1 µm or more, and in which the film is embedded at a depth of 1 µm or more from the bottom part of the step.

### Configuration 3

The substrate according to Configuration 1 or 2, in which the film has an average carbon content of 8 wt % or more and 18 wt % or less.

### Configuration 4

The substrate according to any one of Configurations 1 to 3, in which the silica fine particles have an average primary particle size of 5 nm or more and 150 nm or less.

### Configuration 5

A method for producing a substrate including applying to the substrate a material in which silica fine particles are dispersed in polymethylhydrosilazane or polymethylhydrosiloxazane with a weight-average molecular weight of 400 or more and 20,000 or less as a matrix material, and heating the applied material.

### Configuration 6

The method for producing a substrate according to Configuration 5, in which the silica fine particles have an average primary particle size of 5 nm or more and 150 nm or less.

### Configuration 7

The method for producing a substrate according to Configuration 5 or 6, in which a mixing ratio (weight ratio) of the silica fine particles relative to the matrix material is 3 wt% or more and 200 wt% or less.

### Configuration 8

The method for producing a substrate according to any one of Configurations 5 to 7, in which a ratio of Si-H bonds to Si-Me bonds in a structure of the matrix material is 0.3 or more and 0.9 or less, and in which a ratio of N-H bonds to Si-Me bonds is 0.4 or more and 1.1 or less.

### REFERENCE SIGNS LIST

10 Substrate
12 Film
100 Film-attached substrate

## Claims

1. A substrate comprising:
a film in which silica fine particles are dispersed in a methylhydrosiloxane composition or a methylhydrosiloxazane composition as a matrix material.

2. The substrate according to claim 1,
wherein the substrate has a step of 1 µm or more, and
wherein the film is embedded at a depth of 1 µm or more from the bottom part of the step.

3. The substrate according to claim 1 or 2,
wherein the film has an average carbon content of 8 wt % or more and 18 wt % or less.

4. The substrate according to any one of claims 1 to 3,
wherein the silica fine particles have an average primary particle size of 5 nm or more and 150 nm or less.

5. A method for producing a substrate, comprising:
applying to the substrate a material in which silica fine particles are dispersed in polymethylhydrosilazane or polymethylhydrosiloxazane with a weight-average molecular weight of 400 or more and 20,000 or less as a matrix material; and
heating the applied material.

6. The method for producing a substrate according to claim 5,
wherein the silica fine particles have an average primary particle size of 5 nm or more and 150 nm or less.

7. The method for producing a substrate according to claim 5 or 6,
wherein a mixing ratio (weight ratio) of the silica fine particles relative to the matrix material is 3 wt% or more and 200 wt% or less.

8. The method for producing a substrate according to claim 5 or 6,
wherein a ratio of Si-H bonds to Si-Me bonds in a structure of the matrix material is 0.3 or more and 0.9 or less, and
wherein a ratio of N-H bonds to Si-Me bonds is 0.4 or more and 1.1 or less.
